Europäisches Patentamt

European Patent Office

Office européen des brevets

(11) Publication number: **0 048 768**
**B1**

(12) **EUROPEAN PATENT SPECIFICATION**

(45) Date of publication of patent specification: **22.01.86**

(21) Application number: **80105903.1**

(22) Date of filing: **29.09.80**

(51) Int. Cl.⁴: **H 01 L 23/48,** H 01 L 21/60,
H 01 L 21/58

(54) A semiconductor device with a semiconductor element soldered on a metal substrate.

(43) Date of publication of application:
**07.04.82 Bulletin 82/14**

(45) Publication of the grant of the patent:
**22.01.86 Bulletin 86/04**

(84) Designated Contracting States:
**DE FR GB IT**

(56) References cited:
EP-A-0 015 053
DE-A-1 464 687
DE-A-2 930 789
FR-A-2 207 358

(73) Proprietor: **Kabushiki Kaisha Toshiba
72, Horikawa-cho Saiwai-ku
Kawasaki-shi Kanagawa-ken 210 (JP)**

(72) Inventor: **Sekiba, Toshinobu
205 Green Haimu 749 Kuji
Takatsu-ku Kawasaki-shi (JP)**

(74) Representative: **Henkel, Feiler, Hänzel & Partner
Möhlstrasse 37
D-8000 München 80 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a semiconductor device comprising a semiconductor element soldered to a metal substrate. Such a semiconductor device constitutes a circuit.

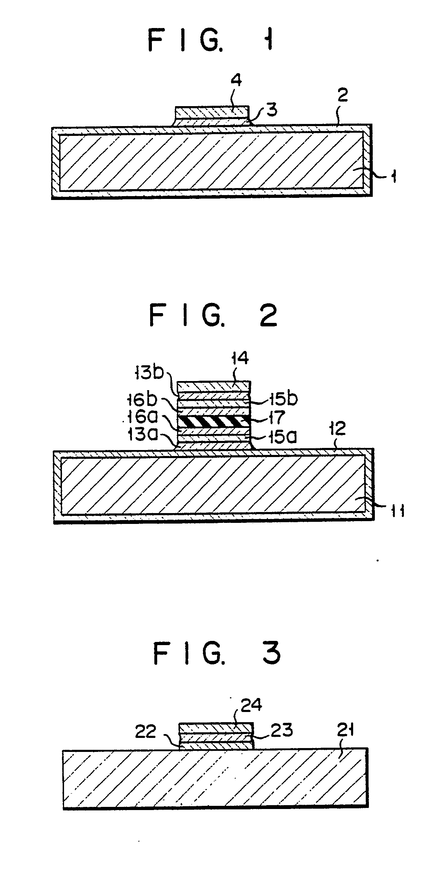

Semiconductor devices called modules or stacks are conventionally known which include one or more semiconductor elements, for example, diodes which are soldered on a metal substrate. The basic construction of such a semiconductor device is such that a semiconductor element such as a diode or transistor is secured, by soldering, at a predetermined position on a copper substrate which is a heat-discharging plate. However, a semiconductor device of such construction has been defective in that it is heavy in weight and expensive to manufacture, since the substrate is made of copper. Furthermore, since it is difficult to cast a copper substrate, formation of heat-discharging wings on the substrate for facilitating heat discharge from the semiconductor element is difficult. In order to eliminate such problems, a semiconductor device is known which uses an aluminum substrate which is light in weight, inexpensive to manufacture and easy to cast. As shown in Fig. 1, direct soldering on an aluminum surface is difficult, so that a metal layer 2 of copper, nickel or the like is formed on the surface of an aluminum substrate 1 by plating or hot pressing. A semiconductor device is manufactured by attaching a semiconductor element 4 by a solder layer 3 to the metal layer 2. However, the metal layer 2 is formed over the entire surface of the aluminum substrate 1, so that formation of the metal layer in a desired configuration corresponding to the shape of the semiconductor element is extremely difficult. Accordingly, the unnecessary part of the metal layer 2 must be removed by, for example, etching, causing problems with respect to the packing density of the semiconductor device. Furthermore, a considerable length of time is required for forming the metal layer 2 of a predetermined thickness by plating, causing more problems.

For electrical insulation between the semiconductor element and the metal substrate, an insulating layer of, for example, ceramic material must be interposed therebetween. However, since the soldering of an insulating layer of ceramic and so on is very difficult, several intermediate layers must be formed between the solder layer and the insulating layer. For example, as shown in Fig. 2, a solder layer 13a is formed on a metal layer 12 of copper, nickel or the like formed on the surface of an aluminum substrate 11. A nickel layer 15a and a molybdenum or tungsten layer 16a are formed thereover, in the order named, by plating, deposition or the like. An insulating layer 17 is formed on the layer 16a by deposition or the like, and a molybdenum or tungsten layer 16b and a nickel layer 15b are formed thereover. A semiconductor element 14 is attached through a solder layer 13b on the nickel layer 15b. In another method, an insulating plate of a ceramic formed by sintering is used. On both surfaces of the insulating plate are formed molybdenum or tungsten layers by a method such as metallizing. Metal layers of nickel, copper or the like are formed thereover. An insulating plate processed in this manner is attached by soldering to a copper substrate or a nickel substrate having a metal layer which allows soldering. The manufacture of a semiconductor device with a semiconductor element insulated from a metal substrate is extremely cumbersome, and the manufacturing efficiency is inferior.

Although an example of an aluminum substrate is shown in Fig. 2, a copper substrate is the same in that many intermediate layers must be formed for forming an insulating layer.

In document DE—A—29 30 789 there is described a semiconductor device comprising a semiconductor element soldered to a metal substrate, the semiconductor element being provided with a metal layer of Ni and a solder layer of Au-Ge.

Furthermore, in document EP—A—15053 there is described a semiconductor device comprising semiconductor elements, soldered to a metal substrate provided with an insulating layer of a ceramic material sprayed on a portion of the substrate, a metal layer being deposited on the insulating layer and lying between the latter and the semiconductor device.

It is an object of the present invention to provide a semiconductor device which is easy to manufacture, compact in size, which enables higher packing density, which has excellent ability to discharge heat from the semiconductor element to the metal substrate and in which the adhesion between the two is excellent. It is still another object of the present invention to provide a semiconductor device which includes a semiconductor element attached to a metal substrate with an insulating layer therebetween, which is easy to manufacture, and which is excellent in adhesion and heat-discharging characteristics.

A semiconductor device according to the present invention comprises a semiconductor element soldered to a metal substrate, a sprayed metal layer formed at a predetermined position in a shape corresponding to that of the semiconductor element on a surface of said metal substrate, the metal layer consisting of a metal selected from the group consisting of copper, nickel, tin, and silver and having a thickness within the range of 0.05—0.4 mm, and a solder layer formed on said metal layer for securely attaching said semiconductor element.

The semiconductor device of the present invention, in another aspect, comprises a semiconductor element soldered to a metal substrate, a sprayed insulating layer which is formed at a predetermined position in a shape corresponding to that of the semiconductor element on a surface of said metal substrate and has a thickness within the range of 0.05—0.4 mm, a metal layer which is formed on said sprayed insulating layer by spraying in a shape corresponding to that of the semiconductor element, consists of a metal selected from the group consisting of copper, nickel, tin and silver and has a thickness within the range of 0.05—0.4 mm, and a solder layer formed on said metal layer for securely attaching said semiconductor element.

Thus, the metal layers and insulating layers are formed by spraying on the desired parts of the surface of the metal substrate so that the manufacture of the semiconductor device is easy and efficient, and the obtained semiconductor device may be made small in size and may be packed with a higher packing density.

The invention can be more fully understood from the following detailed description when taken in conjunction with the accompanying drawings, in which:

Fig. 1 is a sectional view of a conventional semiconductor device with a semiconductor element attached to a metal substrate;

Fig. 2 is a sectional view of a conventional semiconductor device with an insulating layer interposed between the metal substrate and the semiconductor element;

Fig. 3 is a sectional view of a semiconductor device in accordance with an embodiment of the present invention in which a semiconductor element is attached to the metal substrate by a sprayed metal layer;

Fig. 4 is a sectional view of a semiconductor device in accordance with another embodiment of the present invention in which a sprayed insulating layer is interposed between the metal substrate and the semiconductor element; and

Fig. 5 is a sectional view of a semiconductor device in accordance with still another embodiment of the present invention, which includes one semiconductor element attached to a metal substrate by a sprayed metal layer and another semiconductor element attached by a sprayed insulating layer and a sprayed metal layer.

In a semiconductor device as shown in Fig. 3, a sprayed metal layer 22 is formed by spraying on a predetermined part of the surface of a metal substrate 21, in a shape corresponding to that of a semiconductor element 24. A solder layer 23 of a general Sn-Pb based or Sn-based substance is formed on the sprayed metal layer 22, and the semiconductor element 24 such as a diode or transistor is securely fixed by this solder layer 23. In a semiconductor device of this construction, the semiconductor element 24 and the metal substrate 21 are electrically connected.

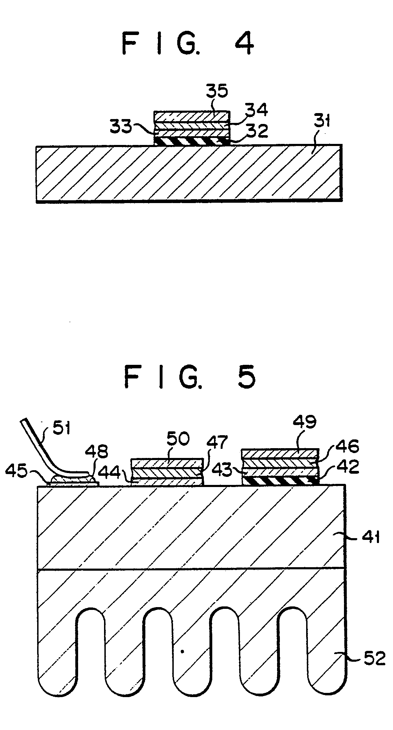

A semiconductor device with an electrically insulated semiconductor element from a metal substrate is shown in Fig. 4 a sprayed insulating layer 32 is formed in a shape corresponding to that of a semiconductor element 35, on a predetermined part of the surface of a metal substrate 31. A sprayed metal layer 33 is further formed thereover. A general solder layer 34 is formed on the sprayed metal layer 33, and the semiconductor element 35 is attached using this solder layer 34.

The substrate is made of metal such as aluminum and copper which are generally used. An aluminum substrate is preferable from the point of view of a lighter semiconductor device and ease in the casting of the substrate.

The sprayed metal layer is copper, nickel, tin or silver, since they provide excellent adhesion between the solder layer and metal substrate and have excellent electrical and thermal conductivity. The sprayed insulating layer is made of an electrically insulating material, i.e. ceramics such as alumina, and plastics. Formation of the sprayed metal layer and the sprayed insulating layer may be performed by a known spraying technique. As spraying techniques, flame spraying utilizing a gas flame and arc spraying utilizing an electric arc and so on are known. However, plasma spraying is preferable which is capable of melting a material of a high melting point and providing high kinetic energy. The spraying conditions such as the spraying distance, the current and the voltage for spraying may be suitably selected according to the kind of metals and the insulating material to be sprayed. For spraying the metals and insulating material, the part of the surface of the metal substrate other than the predetermined part to be sprayed on is masked, and the predetermined part is preferably matted in advance by methods such as sand blasting. The thickness of the sprayed metal layer, formed by spraying, is preferably in the range of 0.05—0.4 mm, and the thickness of the sprayed insulating layer is preferably in the range of 0.05—0.4 mm. The mean coarseness of the surface of the sprayed layer is preferably 10—100 μm for good adhesion with other layers.

Fig. 5 shows an embodiment of a semiconductor device for rectifying an AC current into a DC current. Referring to Fig. 5, an insulating layer 42 is formed by spraying on part of the surface of an aluminum substrate 41. A first sprayed metal layer 43 is formed over the sprayed insulating layer 42. A second sprayed metal layer 44 is formed on another part of the surface of the substrate 41. For connection with wiring 51 from the substrate 41, a third sprayed metal layer 45, may be simultaneously formed. General solder layers 46, 47 and 48 are respectively formed on the first, second and third sprayed metal layers 43, 44 and 45. Diode elements 49 and 50 are respectively adhered to the first and second solder layers 46 and 47 and the wiring 51 is connected to the third solder layer 48. Of the two semiconductor elements 49 and 50 attached to the same substrate 41, the element 49 is electrically insulated from the substrate 41 by the sprayed insulating layer 42. A heat-discharging wing 52 is formed on the substrate 41.

According to the present invention, semiconductor elements may be very easily attached, utilizing sprayed metal layers and sprayed insulating layers, to a substrate which is difficult to directly solder, such as an aluminum substrate. In particular, when formation of an insulating layer of, for example, ceramic is required, a semiconductor device may be manufactured with processes comprising drastically decreased steps in comparison with a conventional device as shown in Fig. 2.

Since the sprayed metal layers and the sprayed insulating layers may be formed on parts of the surface of a metal substrate in shapes corresponding to the shapes of the semiconductor elements to be attached, the semiconductor device may be made compact in size and packed with higher density.

With the semiconductor device of the present invention, the adhesion of the semiconductor element to the metal substrate is improved. This is attributed to the fact that the sprayed metal layers and the sprayed insulating layers are securely attached to the metal substrate, and the solder layer is securely fixed to the surface of the respective sprayed layers which is matted and having fine holes. Although adhesion between insulating layers and metal is not good in general, the sprayed insulating layers of the present invention adhere strongly to the metal substrate and the solder layer.

Surprisingly, the heat-discharging characteristics are vastly improved with the semiconductor device including a sprayed insulating layer as shown in Fig. 4, in comparison with a conventional device including a insulating layer as shown in Fig. 2. With a semiconductor device as in Fig. 2 of the same dimensions as the semiconductor device shown in Fig. 4 having an sprayed alumina insulating layer 30 mm in width and 30 mm in length on a metal substrate 45 mm in width and 36 mm in length, the temperature of the semiconductor element was measured after operation for a hour at 50 W. The temperature difference between the semiconductor element and the metal substrate was 15°C with the conventional device, and it was 5°C with the device of the present invention.

## Claims

1. A semiconductor device comprising a semiconductor element (24) soldered to a metal substrate (21), a sprayed metal layer (22) formed at a predetermined position in a shape corresponding to that of the semiconductor element on a surface of said metal substrate (21), the metal layer consisting of a metal selected from the group consisting of copper, nickel, tin, and silver and having a thickness within the range of 0.05—0.4 mm, and a solder layer (23) formed on said metal layer (22) for securely attaching said semiconductor element (24).

2. A semiconductor device as claimed in claim 1 wherein said metal substrate (21) consists of aluminum or copper.

3. A semiconductor device comprising a semiconductor element (35) soldered to a metal substrate (31), a sprayed insulating layer (32) which is formed at a predetermined position in a shape corresponding to that of the semiconductor element on a surface of said metal substrate (31) and has a thickness within the range of 0.05—0.4 mm, a metal layer (33) which is formed on said sprayed insulating layer (32) by spraying in a shape corresponding to that of the semiconductor element, consists of a metal selected from the group consisting of copper, nickel, tin and silver and has a thickness within the rnage of 0.05—0.4 mm, and a solder layer (34) formed on said metal layer (33) for securely attaching said semiconductor element (35).

4. A semiconductor device as claimed in claim 3 wherein said sprayed insulating layer (32) consists of a ceramic or a plastic material.

## Patentansprüche

1. Halbleitervorrichtung mit einem Halbleiterelement (24), das an ein Metallsubstrat (21) gelötet ist, einer aufgesprühten Metallschicht (22), die in einer vorbestimmten Lage in einer Form entsprechend derjenigen des Halbleiterelementes auf der Oberfläche des Metallsubstrates (21) geformt ist, wobei die Metallschicht aus einem Metall besteht, das aus der aus Kupfer, Nickel, Zinn und Silber bestehenden Gruppe gewählt ist sowie eine Dicke innerhalb des Bereiches von 0,05 bis 0,4 mm aufweist, und einer Lotschicht (23), die auf der Metallschicht (22) zum sicheren Befestigen des Halbleiterelementes (24) ausgeführt ist.

2. Halbleitervorrichtung nach Anspruch 1, dadurch gekennzeichnet, daß das Metallsubstrat (21) aus Aluminium oder Kupfer besteht.

3. Halbleitervorrichtung mit einem Halbleiterelement (35), das an ein Metallsubstrat (31) gelötet ist, einer aufgesprühten Isolierschicht (32), die in einer vorbestimmten Lage in einer Form entsprechend derjenigen des Halbleiterelementes auf einer Oberfläche des Metallsubstrates (31) vorgesehen ist und eine Dicke innerhalb des Bereiches von 0,05 bis 0,4 mm hat, einer Metallschicht (33), die auf der aufgesprühten Isolierschicht (32) durch Aufsprühen in einer Form entsprechend derjenigen des Halbleiterelementes ausgeführt ist, die aus einem Metall besteht, das aus der Gruppe ausgewählt ist, die aus Kupfer, Nickel, Zinn und Silber besteht, und die eine Dicke innerhalb des Bereiches von 0,05 bis 0,4 mm hat, und einer Lotschicht (34), die auf der Metallschicht (33) zum sicheren Befestigen des Halbleiterelementes (35) ausgeführt ist.

4. Halbleitervorrichtung nach Anspruch 3, dadurch gekennzeichnet, daß die aufgesprühte Isolierschicht (32) aus einem Keramik- oder einem Kunststoff-Material besteht.

## Revendications

1. Dispositif à semiconducteur, caractérisé en ce qu'il comprend un élément à semiconducteur (24) soudé sur un substrat de métal (21), une couche de métal pulvérisée (22) formée à une position prédéterminée suivant une forme correspondant à celle de l'élément à semiconducteur sur une surface du substrat de métal (21), la couche de métal étant constituée d'un métal choisi dans le groupe composé du cuivre, du nickel, de l'étain et de l'argent et ayant une épaisseur comprise entre 0,05 et 0,4 mm, et une couche de soudure (23) formée sur la couche de métal (22) pour fixer solidement l'élément à semiconducteur (24).

2. Dispositif à semiconducteur selon la revendication 2, caractérisé en ce que le substrat de métal (21) est constitué d'aluminium ou de cuivre.

3. Dispositif à semiconducteur, caractérisé en ce qu'il comprend un élément à semiconducteur (35) soudé sur un substrat de métal (31), une couche isolante pulvérisée (32) qui est formée à une position prédéterminée suivant une forme correspondant à celle de l'élément à semiconducteur sur une surface du substrat de métal (31) et qui a une épaisseur comprise entre 0,05 et 0,4 mm, une couche de métal (33) qui est formée sur la couche isolante pulvérisée (32) par pulvérisation suivant une forme correspondant à celle de l'élément à semiconducteur, constituée d'un métal choisi dans le groupe composé du cuivre, du nickel, de l'étain et de l'argent et qui a une épaisseur comprise entre 0,05 et 0,4 mm, et une couche de soudure (34) formée sur la couche de métal (33) pour fixer solidement l'élément à semiconducteur (35).

4. Dispositif à semiconducteur selon la revendication 3, caractérisé en ce que la couche isolante pulvérisée (32) est constituée d'une céramique ou d'une matière plastique.

# F I G. 1

4
3
2
1

# F I G. 2

13b
14
16b
15b
16a
17
16a
13a
15a
12
11

# F I G. 3

24
22
23
21

# F I G. 4

# F I G. 5